# FASCICULE DE BREVET EUROPEEN

(11) **EP 2 335 349 B1**
(45) Date de publication et mention de la délivrance du brevet: **09.05.2012**
(21) Numéro de dépôt: 09782522.8
(22) Date de dépôt: 02.09.2009
(51) Int. Cl.: H03D 9/06

(54) **MELANGEUR BI-MODE**
MISCHER MIT ZWEI BETRIEBSARTEN
DUAL-MODE MIXER

(30) Priorité: 10.09.2008 FR 0856080
(43) Date de publication de la demande: 22.06.2011
(73) Titulaire: Thomson Licensing, 92130 Issy-les-Moulineaux (FR)
(72) Inventeur: LO HINE TONG, Dominique, 92648 Boulogne cedex (FR); COUPEZ, Jean-Philippe, 29200 Brest (FR); LE PENNEC, Francois, 92648 Boulogne cedex (FR)
(74) Mandataire: Browaeys, Jean-Philippe
(86) Numéro de dépôt international: PCT/EP2009/061357
(87) Numéro de publication internationale: WO 2010/028998

(56) Documents cités:
- US-A- 4 340 975
- US-A1- 2007 072 573
- ITOH T ET AL: "Digital wireless sensor server using an adaptive smart-antenna/retrodirective array" IEEE TRANSACTIONS ON VEHICULAR TECHNOLOGY, IEEE SERVICE CENTER, PISCATAWAY, NJ, US, vol. 52, no. 5, 1 septembre 2003 (2003-09-01), pages 1181-1188, XP011101006 ISSN: 0018-9545 cité dans la demande
- THORSTEN BRABETZ ET AL: "Balanced Subharmonic Mixers for Retrodirective-Array Applications" IEEE TRANSACTIONS ON MICROWAVE THEORY AND TECHNIQUES, IEEE SERVICE CENTER, PISCATAWAY, NJ, US, vol. 49, no. 3, 1 mars 2001 (2001-03-01), XP011038274 ISSN: 0018-9480 cité dans la demande

## Description

L'invention concerne un mélangeur de signaux à différentes fréquences pour une tête d'émission/réception (en anglais : front-end) d'un système semi-duplex (en anglais : half duplex) rétrodirectif comportant un réseau d'antennes.

Cette invention s'inscrit dans le cadre d'un projet concernant les transmissions sans fils en technologie GWT (Gigabit-Wireless-Technology) dans les systèmes de radiocommunication.

Les systèmes rétrodirectifs, sont capables, après avoir reçu un signal d'une direction donnée sur un réseau d'antennes, de transmettre de manière automatique une réponse dans la même direction, sans connaissance a priori de l'angle d'arrivée de ce signal. Un système semi-duplex est capable de transmettre des informations sur un canal bidirectionnel dans un seul sens à la fois.

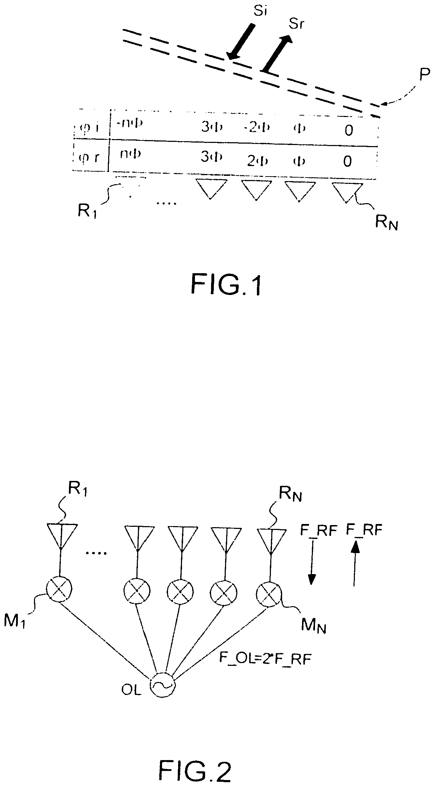

Des systèmes d'antennes rétrodirectifs pour les communications sans fils sont connus du document « retrodirective antenna systems for wireless communications » de Dylan Jorgensen -CNSR 2003. Ce document décrit des réseaux passifs tels le réseau de « Van Atta ». Ce réseau est représenté par la figure 1. Il est construit en utilisant un réseau linéaire d'éléments rayonnants R1-RN interconnectés par des lignes de transmission de longueurs égales. Le signal entrant Si avec une phase relative ϕr sera retransmis en sortie avec la phase relative opposée ϕr. Le signal sortant Sr sera donc rétroréfléchi comme montré en figure 1. Un plan P des signaux entrants et sortants est représenté perpendiculaire à la direction de propagation des signaux.

D'autres réseaux utilisent des mélangeurs hétérodynes, tel le réseau représenté par la figure 2. Dans un réseau à mélangeurs hétérodynes, à chacun des mélangeurs M1-MN connectés aux éléments rayonnants R1-RN, est associé un oscillateur local OL dont la fréquence F-OL est double de la fréquence F-RF du signal RF entrant. Le mélange des 2 signaux aux fréquences F-OL et F-RF donne ainsi un signal sortant à la même fréquence que celle du signal RF entrant mais avec une phase conjuguée.

Assurant la fonction de transposition de fréquence, le mélangeur est un composant essentiel de ces réseaux d'émetteurs et récepteurs.

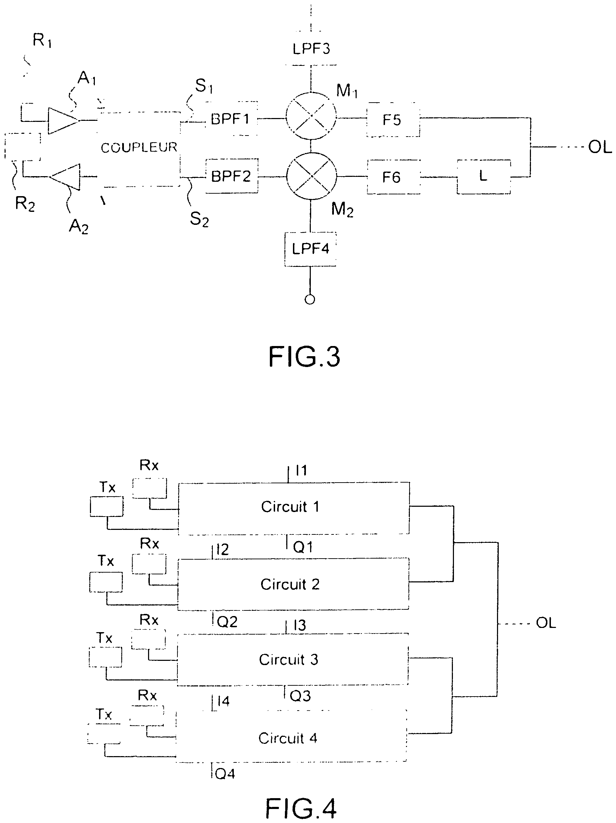

Du document "Digital Wireless Sensor Server Using an Adaptive Smart-Antenna/Retrodirective Array" de Ryan Y. Miyamoto - IEEE TRANSACTIONS ON VEHICULAR TECHNOLOGY, VOL. 52, NO. 5, SEPTEMBER 2003 1181, il est connu une architecture d'un circuit frontal émission/réception d'un système rétrodirectif semi-duplex utilisant plusieurs mélangeurs. L'architecture d'un tel circuit élémentaire semi-duplex d'un système de radiocommunications, comme par exemple les systèmes Wifi répondant aux normes IEEE.802.11a/b/g, est illustré en figure 3.

Le principe de fonctionnement d'un tel circuit, en référence avec la figure 3, est le suivant :

En mode réception Rx de ce circuit, le signal entrant de fréquence F-RF, par exemple 5,24GHz, reçu par un des d'éléments rayonnants R1, est amplifié par un amplificateur A1 et appliqué à l'entrée Σ d'un coupleur hybride (Rat-race coupler). Les signaux S1 et S2 de sortie du coupleur sont filtrés puis appliqués à la voie RF des mélangeurs M1, M2 et mélangés soit directement, soit avec une ligne de retard L avec un signal en provenance d'un oscillateur local OL de fréquence FOL-R approximativement égale à la moitié de celle F-RF du signal entrant, soit par exemple 2,625 GHz. Les mélangeurs fonctionnent ici dans un mode dit subharmonique, le produit du mélange des fréquences FOL-R et F-RF donne ainsi une fréquence intermédiaire FI proche de zéro, soit en bande de base et les signaux sont émis sur les voies I/Q en bande de base à cette fréquence. Le retard ajouté par la ligne de retard est de 45° à la fréquence de réception FOL-R. De ce fait, les mélangeurs étant en mode subharmonique, les signaux en fréquence FI en sortie des mélangeurs sont en quadrature de phase et permettent ainsi d'appliquer les schémas de démodulations classiques associées.

En mode transmission de ce circuit, il faut assurer la rétrodirectivité. Pour ce faire et comme expliqué précédemment et décrit en figure 2, il faut utiliser une fréquence FOL-T de l'oscillateur local OL approximativement double de celle F-RF du signal RF, soit par exemple 10,5GHz. Les mélangeurs M1, M2 fonctionnent alors dans un mode hétérodyne classique. A la fréquence FOL-T, la différence de phase entre les 2 voies de l'oscillateur local OL est de180°, les signaux issus des 2 mélangeurs et appliqués au coupleur hybride par l'intermédiaire des filtres BPF1 et BPF2, sont combinés sur la sortie Δ. Les signaux émis sur cette sortie Δ sont les conjugués de ceux reçus sur l'entrée Σ. Ils sont ensuite amplifiés par l'amplificateur A2 et retransmis par l'élément rayonnant R2. D'autre part, les signaux émis peuvent être modulés d'une manière connue en elle-même, en injectant sur les voies I/Q, en bande de base, des données à transmettre.

Quant aux dispositifs de filtrage associés aux mélangeurs, ils permettent d'isoler les signaux les uns des autres afin d'assurer un fonctionnement optimal. Ainsi, les filtres passe-bande BPF1, BPF2 sur la voie RF laissent passer la bande utile et rejettent la fréquence F-FI et les 2 fréquences de l'oscillateur FOL-R et FOL-T. Les filtres passe-bas LPF3, LPF4 sur les voies I/Q ont une fréquence de coupure en bande de base, rejetant ainsi la bande RF et les 2 fréquences FOL-R et FOL-T.

Et les filtres F5 et F6 sur les voies OL des signaux de l'oscillateur local OL, sont une combinaison de filtre passe-haut, pour rejeter la fréquence F-FI, et de filtre réjecteur, pour rejeter la fréquence F-RF.

Ainsi, l'architecture décrite précédemment implique l'utilisation d'un mélangeur fonctionnant suivant 2 modes : mode harmonique simple en émission et mode subharmonique en réception.

Les mélangeurs décrits ci-dessus comprennent un simple transistor FET en technologie AsGa.

Or les performances intrinsèques de ces mélangeurs sont faibles. En termes de pertes de conversion par exemple, elles sont de l'ordre de 13dB en tenant compte d'un gain de conversion en réception de 7dB et d'un gain d'amplificateur de 20dB. Ces pertes de conversion élevées qui doivent être compensées par le gain des amplificateurs, ont donc un impact important sur le bilan énergétique du système rétrodirectif. Un prototype montre une consommation en puissance de 160mW par voie d'émission/réception TX/RX, soit 640mW pour un réseau à 4 circuits, circuit 1 - circuit 4 tel représenté par la figure 4. Chaque circuit étant défini conformément à la figure 3 comme comprenant des amplificateurs A1 et A2, un coupleur, des mélangeurs M1, M2, une ligne de retard L et des filtres et fonctionnant comme décrit précédemment.

Une autre structure de mélangeur utilisable consiste à utiliser des paires de diodes dans une configuration antiparallèles et est proposée dans le document « balanced subharmonic mixers for retrodirective array application» de Thorsten Brabetz ou dans le document US 2007/072573A.

De même, le document intitulé « méthode de conception des mélangeurs millimétriques » de Peter Butterworth - Université de Limoges, décrit également une réalisation de mélangeurs sous-harmoniques à partir d'une paire de diodes antiparallèles en mode réception. La figure 5b représente une telle configuration en mode réception. Deux diodes D1, D2 montées en tête bêche sont reliées d'un côté à la masse et de l'autre aux voies des signaux émission/réception RF et FI et du signal issu de l'oscillateur local OL. Des mélangeurs simples ou harmoniques utilisés en émission ont une topologie de type parallèle ou shunt, telle que représentée schématiquement en Figure 5a. Ces mélangeurs simples sont couramment utilisés. La cathode de la diode D3 est reliée à la masse tandis que l'anode est reliée au point d'accès commun des voies RF, OL et FI pour l'émission ou la réception des signaux RF, OL et FI.

Bien que ce document propose un mélangeur en mode émission et un mélangeur en mode réception, il ne propose pas de mélangeurs bi-mode car la séparation des fréquences ne peut être réalisée simplement.

L'invention propose donc un mélangeur bi-mode avec de bonnes performances. L'invention consiste en un mélangeur de signaux à différentes fréquences selon la revendication 1 . . Dans un mode de réalisation le réseau adaptatif comprend un réseau d'impédances telles que, à la fréquence du signal de réception F-RF, à la fréquence du signal de l'oscillateur local OL de réception F-OLR et à la fréquence d'émission du signal intermédiaire F-FI corresponde un état de court circuit et à la fréquence de l'oscillateur local OL d'émission F-OLT, corresponde un état de circuit ouvert. Selon une variante de l'invention, le réseau d'impédances comprend une première ligne TL1 demi quart d'onde à la fréquence d'émission F-RF en court circuit, une seconde ligne quart d'onde TL2 et une troisième ligne demi-onde TL3 à cette fréquence d'émission F-RF en circuit ouvert , ces première, seconde et troisième lignes ont chacune une impédance caractéristique d'une valeur de 50ohms et sont jointes au port commun. Dans un mode de réalisation, le réseau de filtrage pour l'isolation entre les différentes voies du mélangeur comprend un filtre RF, relié au port de la voie RF, présentant un circuit ouvert à la fréquence d'émission du signal intermédiaire F-FI ainsi qu'aux fréquences F-OLR et F-OLT de l'oscillateur local, un filtre OL, relié au port de la voie OL, présentant un circuit ouvert aux fréquences d'émission/réception F-FI et F-RF et un filtre FI, relié au port de la voie FI et présentant un circuit ouvert à la fréquence de réception F-RF et aux fréquences F-OLR et F-OLT de l'oscillateur local, et les différents filtres sont adaptés à leur fréquence nominale de fonctionnement.

Le mélangeur selon l'invention a des pertes de conversion faibles, et quasiment identiques quelque soit le mode de fonctionnement. Le concept simplement basé sur l'utilisation de diodes Schottky est à bas coût et le réseau d'adaptation auto-configurable de manière passive pour la sélection du mode de fonctionnement permet une consommation de puissance associée faible.

Les caractéristiques et avantages de l'invention mentionnée ci-dessus, ainsi que d'autres, apparaîtront plus clairement à la lecture de la description suivante, faite en relation avec les dessins joints, dans lesquels :
- La figure 1 déjà décrite, représente un réseau rétrodirectif passif selon un état de la technique ;
- La figure 2 déjà décrite, représente un réseau rétrodirectif hétérodyne selon un état de la technique ;
- La figure 3 déjà décrite, représente l'architecture d'un circuit frontal émission/réception d'un système rétrodirectif semi-duplex selon un état de la technique ;

- La figure 4 déjà décrite, représente un système rétrodirectif semi-duplex à 4 circuits selon un état de la technique ;
- Les figures 5a et 5b déjà décrites, représentent des réseaux de diodes pour les mélangeurs du système rétrodirectif de la figure 4 connus d'un état de la technique ; -la figure 6 représente un schéma de réseau à diodes comprenant un réseau adaptatif pour le mélangeur bi-mode selon l'invention ;
- La figure 7 représente un schéma du mélangeur bi-mode selon l'invention ;
- La figure 8 représente un réseau adaptatif du mélangeur selon l'invention ;
- Et les figures 9a, 9b et 9c représentent respectivement des réseaux de filtrage RF, OL et FI d'un mélangeur bi-mode selon l'invention. Pour simplifier la description, les mêmes références seront utilisées dans ces dernières figures pour désigner les éléments remplissant des fonctions identiques.

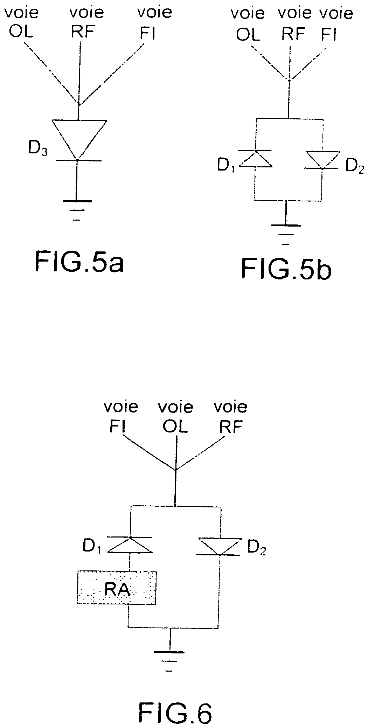

L'invention concerne donc un mélangeur bi-mode tel représenté par la figure 6 et utilise un réseau de diodes formé par une paire de diodes antiparallèles D1, D2 dans un montage de type shunt pour assurer un mélange optimal des fréquences tant en émission (mode harmonique) qu'en réception (mode subharmonique). Une topologie à 2 diodes D1, D2 mises en tête-bêche (antiparallèles), telle illustrée en figure 5b, est apte à réaliser la fonction d'un mélangeur subharmonique selon l'invention. L'anode de l'une des diodes D1 et la cathode de l'autre diode D2 sont reliées à la masse. La cathode de la diode D1 et l'anode de la diode D2 sont reliées au point d'accès commun des voies RF, OL et FI pour l'émission ou la réception des signaux RF, OL et FI.

L'une des diodes D1 est mise à la masse à travers un réseau adaptatif passif RA apte à s'auto-configurer selon l'un des modes de fonctionnement choisi, l'émission ou la réception. L'autre diode D2 est directement reliée à la masse par sa cathode. Ce circuit permet par ailleurs des conditions de charge spécifiques pour un fonctionnement bi-modal.

A ce circuit adaptatif de modes et afin d'assurer une bonne isolation entre les différents accès RF, OL et FI du mélangeur reliés aux voies RF, OL et FI pour l'émission ou la réception des signaux RF, OL et FI, des réseaux de filtrage RF, OL et FI présentent des charges appropriées au point d'accès B aux diodes, selon les fréquences en jeu.

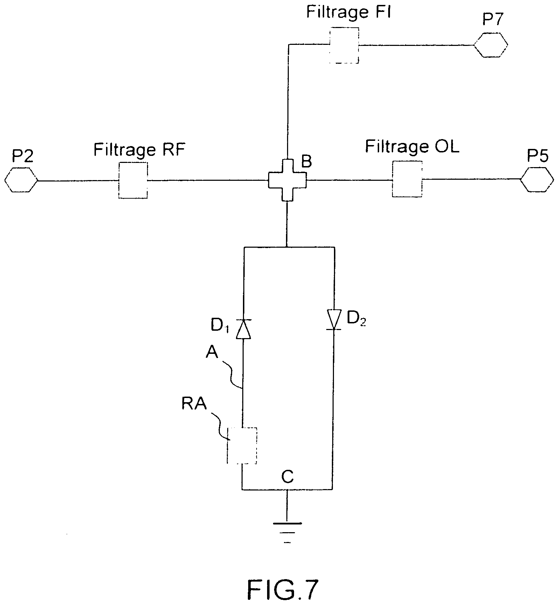

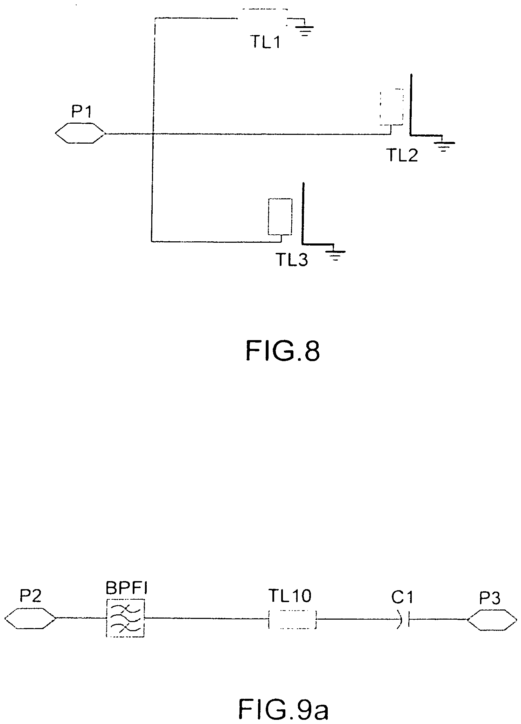

Les diodes Schottky sont couramment utilisées pour concevoir de tels mélangeurs. En effet, elles ont un coût très faible et elles permettent d'atteindre des pertes de conversion relativement faibles (6-8dB) avec des puissances d'oscillateur local OL assez faibles aussi (2-7dBm). L'idée de l'invention est donc de concevoir un mélangeur bi-mode tel représenté par la figure 7 à partir de la topologie à diodes antiparallèles. En ajoutant à l'une des diodes un réseau adaptatif RA, comme illustré en figure 6, il est ramené au point A de connexion entre ce réseau et l'anode de l'une des diodes un circuit ouvert (CO) quand le dispositif est en mode émission. Lorsque le dispositif est en mode réception, il est ramené au point A un court-circuit (CC). La figure 8 représente un tel réseau adaptatif.

Ce réseau adaptatif RA permettant de garantir un fonctionnement optimal du mélangeur bi-mode doit donc adapter les impédances selon les fréquences en jeu. C'est-à-dire que ce réseau doit ramener un court-circuit à la fréquence RF, à la fréquence OL de réception et à la fréquence FI ainsi qu'un circuit ouvert à la fréquence OL d'émission.

Dans la bande WIFI des fréquences de 5GHz, par exemple, avec :
- Une fréquence de réception de F-RX=5.24GHz
- Une fréquence intermédiaire de F-FI=10MHz
- Soit une fréquence d'oscillateur local OL en réception de FOL-30 R=2.625GHz
- Une fréquence d'émission de F-TX=5.26GHz
- Soit, une fréquence d'oscillateur local OL en émission de FOLT=10.5GHz.

Un réseau adaptatif RA permettant de garantir un fonctionnement optimal du mélangeur bi-mode doit donc ramener les impédances suivantes selon les fréquences en jeu :
- court-circuit aux fréquences RF autour de 5.25GHz ;
- court-circuit à la fréquence OL de réception de 2.625GHz ;
- circuit ouvert à la fréquence OL d'émission de 10.5GHz ;
- court-circuit à la fréquence FI de 10MHz.

Et conformément à la figure 8, un réseau adaptatif RA suivant est proposé : Il comprend 3 lignes idéales, chacune d'impédance caractéristique d'une valeur de 50 ohms, jointes à un port commun P1 qui est le point A de la figure 7.
- Une 1^{ère} ligne TL1 en court-circuit, de longueur électrique égale à λ/8 (λétant la longueur d'onde) à la fréquence RF de 5.25GHz ;
- Une 2^{ème} ligne TL2 en circuit ouvert, de longueur λ/4 à la même fréquence ;
- Une 3^{ème} ligne TL3 en circuit ouvert, de longueur λ/2 à la même fréquence.

Ce réseau est capable de remplir les conditions de charge selon les modes de fonctionnement et définies précédemment:
- Le court-circuit au point A à 5.25GHz est obtenu grâce à la ligne TL2. En effet, il est connu de l'homme du métier qu'une ligne quart d'onde est un inverseur d'impédance, ici le circuit ouvert en bout de la ligne TL2 ramène donc un court-circuit à son entrée.
- Le court-circuit à 2.625GHz est obtenu grâce à la ligne TL3. En effet, cette ligne a une longueur électrique égale au quart d'onde à cette fréquence de 2.625GHz qui est la fréquence moitié de 5.25GHz et le circuit ouvert à son extrémité ramène donc bien aussi un circuit ouvert à son entrée.
- Le circuit ouvert à 10.5GHz est assuré par les 3 lignes :
   - TL1 est une ligne quart d'onde à cette fréquence (fréquence double de 5.25GHz), le CC à son extrémité est donc transformé en circuit ouvert à son entrée.
   - TL2 est une ligne demi-onde à la même fréquence, le circuit 30 ouvert à son extrémité est alors ramené à son entrée.
   - TL3 à 10.5GHz a une longueur égale à la longueur d'onde, le circuit ouvert à son extrémité est aussi ramené à son entrée.
- Le court-circuit à 10MHz est assuré sans problème par la ligne TL1 qui est mise à la masse et dont la longueur physique est négligeable par rapport à 35 la longueur d'onde à 10MHz.

Des exemples de réseaux de filtrage RF, OL et FI, sont représentés par les figures 9a-9c.

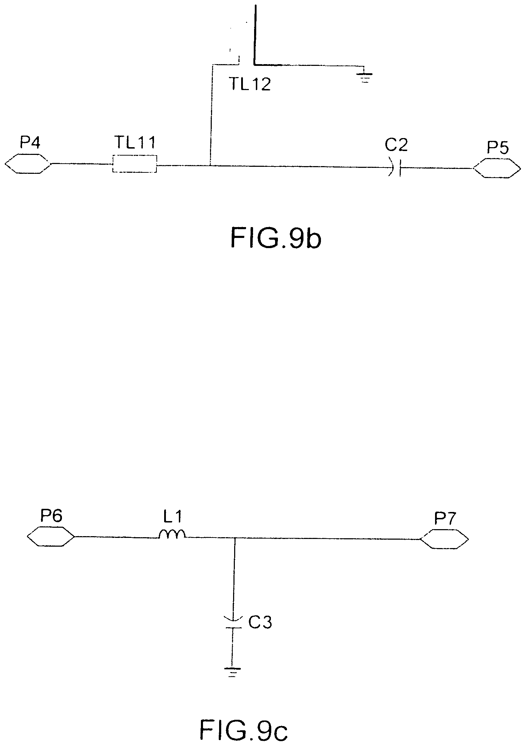

Le réseau de filtrage RF (figure 9a) doit présenter idéalement au niveau des diodes une bonne adaptation à la fréquence RF et un circuit ouvert aux fréquences FI, FOL-R et FOL-T. Le réseau de filtrage OL (figure 9b) doit présenter au niveau des diodes une bonne adaptation aux fréquences OL : FOL-R et FOL-T et un circuit ouvert aux fréquences FI et RF. Le réseau de filtrage FI (figure 9c), doit présenter au niveau des diodes une bonne adaptation à la fréquence FI et un circuit ouvert aux fréquences RF et OL d'émission et réception.

Le réseau de filtrage RF représenté par la figure 9a est composé en cascade entre les ports P2 et P3 de :
- un filtre passe-bande BPF1 idéal d'ordre 4, centré autour de 5.25GHz, ayant pour rôle d'isoler la bande RF de celles de la FI, FOL-R et FOL-T ;
- une ligne de transmission idéale TL10 ayant pour rôle de déphaser le signal afin de présenter le circuit ouvert requis aux accès du filtre aux fréquences FO-LR et FOL-T. Il est à noter que la longueur de cette ligne sera à ajuster lors de la simulation complète du mélangeur afin d'en optimiser les performances ;
- et une capacité série C1 ayant pour rôle de présenter le circuit ouvert requis au point d'accès aux diodes à la fréquence FI. Les valeurs suivantes des différents composants de ce réseau de filtrage sont proposées à titre d'exemple :
   - Filtre BPF1 : filtre Chebyshev, N=4, centré sur 5.25GHz, band passante 1.5GHz
   - TL10 : Z=500hm,E=148° (phase à ajuster) F=5.25GHz
   - C1=5pF.

Le réseau de filtrage OL, apte à répondre aux exigences précitées est 30 représenté par la figure 9b et est composé en cascade entre les ports P4 et P5 de :
- une ligne TL12 quart-d'onde à la fréquence RF (5.25GHz) en circuit ouvert, qui ramène donc un court-circuit à son entrée, coupant ainsi le signal RF entre les ports P4 et P5 ;
- une ligne série TL11 quart d'onde à la fréquence RF, permettant de ramener à partir du précédent court-circuit un circuit ouvert au port P4 tel que requis ;
- une capacité série C2 permettant d'avoir aussi un circuit ouvert à la fréquence FI, vu du port P4 du filtre ;Les valeurs suivantes des différents composants de ce réseau de filtrage sont proposées à titre d'exemple :

- TL12: Z=100 Ohm,E=90° F=5.25GHz
- TL11: Z=50 Ohm,E=90° F=5.25GHz
- C2=5pF.

La Figure 9c montre que le réseau de filtrage FI est un simple filtre passe-bas LC d'ordre 2, L1, C3 entre les ports P6 et P7. Les valeurs suivantes des différents composants de ce réseau de filtrage sont proposées à titre d'exemple : L1=44nH, C3=3pF.

Au point de liaison B des diodes antiparallèles, sont connectés les différents ports P3, P4, P6 des réseaux de filtrage tel que décrit précédemment par les figures 9a, 9b et 9c. Des simulations ont été effectuées avec des diodes du commerce en boîtier plastique. Il s'agit par exemple d'une diode de type MACOM-MA4E2054.

On peut remarquer que les pertes de conversion sont relativement faibles, soit environ 7-8dB, que les pertes sont approximativement constantes d'un mode à l'autre et que les niveaux de puissance de l'oscillateur local OL permettant d'atteindre des pertes de conversion minimales sont relativement faibles, entre 1 et 3dBm.

## Revendications

1. Mélangeur de signaux à différentes fréquences correspondant à un mode émission et un mode réception comprenant :
un réseau de diodes comprenant une paire de diodes montées en antiparallèle, un premier point de liaison (C) des diodes étant relié à la masse, le second point de liaison (B) étant relié aux ports de voies de signaux d'émission/réception et au port de voie d'un oscillateur local (OL) à différentes fréquences,
et un réseau de filtrage connecté entre le second point de liaison (B) et chacun des ports des voies d'émission/réception et de la voie de l'oscillateur local.
**caractérisé en ce que**
un réseau adaptatif (RA), pour une utilisation bi-mode, en mode émission et en mode réception, est branché en série dans le réseau de diodes entre le premier point de liaison (C) connecté à la masse et l'anode de l'une des diodes du réseau de diodes, le réseau adaptatif comprenant des moyens pour réaliser un premier état de circuit ouvert en mode d'émission et un second état de court circuit en mode de réception.

2. Mélangeur selon la revendication 1 **caractérisé en ce que** les dits moyens comprennent un réseau d'impédances telles que, à la fréquence du signal de réception , à la fréquence du signal de l'oscillateur local de réception et à la fréquence d'émission du signal intermédiaire corresponde un état de court circuit et à la fréquence de l'oscillateur local d'émission , corresponde un état de circuit ouvert.

3. Mélangeur selon la revendication 2 **caractérisé en ce que** le réseau d'impédances comprend une première ligne (TL1) demi quart d'onde à la fréquence d'émission en court circuit, une seconde ligne quart d'onde (TL2) et une troisième ligne demi-onde (TL3) à cette fréquence d'émission en circuit ouvert, ces première, seconde et troisième lignes ont chacune une impédance caractéristique d'une valeur de 50 ohms et sont jointes au port commun.

4. Mélangeur selon la revendication 1 **caractérisé en ce que** le réseau de filtrage pour l'isolation entre les différentes voies du mélangeur comprend : un filtre de radio fréquence, relié au port de la voie de radio fréquence, présentant un circuit ouvert à la fréquence d'émission du signal intermédiaire ainsi qu'aux fréquences de l'oscillateur local de réception et d'émission, un filtre d'oscillateur local, relié au port de la voie d'oscillateur local, présentant un circuit ouvert aux fréquences d'émission/réception , et un filtre de fréquence intermédiaire, relié au port de la voie de fréquence intermédiaire et présentant un circuit ouvert à la fréquence de réception et aux fréquences de l'oscillateur local de réception et d'émission, et **en ce que** lesdits filtres sont adaptés à leur fréquence nominale de fonctionnement.

## Claims

1. Signal mixer at different frequencies corresponding to a sending mode and a receiving mode comprising:
a diode array comprising a pair of diodes connected in anti-parallel, a first connection point (C) of the diodes being connected to the earth, the second connection point (B) being connected to the sending/receiving signal channel ports and to the channel port of a local oscillator (OL) at different frequencies,
and a filtering network connected between the second connection point (B) and each of the ports of the sending/receiving channels and of the local oscillator channel.
**characterized in that**
an adaptive array (RA), for dual-mode use in sending mode and in receiving mode, is connected in series in the diode array between the first connection point (C) connected to the earth and the anode of one of the diodes of the diode array, the adaptive array comprising means to make a first open circuit state in sending mode and a second short circuit state in receiving mode.

2. Mixer according to claim 1 **characterized in that** said means comprise an impedance network such that, to the frequency of the reception signal, to the frequency of the signal of the local receiving oscillator, to the sending frequency of the intermediate signal corresponds a short circuit state and to the frequency of the local sending oscillator corresponds an open circuit state.

3. Mixer according to claim 2 **characterized in that** the impedance network comprises a first half quarter wave line (TL1) at the sending frequency in short circuit, a second quarter wave line (TL2) and a third half wave line (TL3) at this sending frequency in open circuit, these first, second and third lines each have a characteristic impedance of a value of 50 ohms and are joined at the common port.

4. Mixer according to claim 1 **characterized in that** the filtering network for isolation between the various mixer channels comprises: a radio-frequency filter connected to the port of the radio-frequency channel, presenting an open circuit at the sending frequency of the intermediate signal of the local oscillator as well as at the frequencies of the local receiving and sending oscillator, a local oscillator filter connected to the port of the local oscillator channel presenting an open circuit at the sending/receiving frequencies, and an intermediate frequency filter connected to the port of the intermediate frequency channel and presenting an open circuit at the receiving frequency and at the frequencies of the local receiving and sending oscillator, and **in that** said filters are adapted at their nominal operating frequency.

## Patentansprüche

1. Mischer von Signalen mit unterschiedlichen Frequenzen, die einem Sendemodus und einem Empfangsmodus entsprechen, mit:
- einem Diodengitter mit einem Paar antiparallel geschalteter Dioden, wobei ein erster Verbindungspunkt (C) der Dioden mit der Masse verbunden ist, der zweite Verbindungspunkt (B) mit den Ports für die Wege der Sende- bzw. Empfangssignale und mit dem Port für den Weg eines lokalen Oszillators (OL) mit unterschiedlichen Frequenzen verbunden ist, und
- einem Filternetzwerk, das zwischen dem zweiten Verbindungspunkt (B) und jedem der Ports für die Sende- bzw. Empfangswege und für den Weg des lokalen Oszillators geschaltet ist,
**dadurch gekennzeichnet, dass**
ein adaptives Netzwerk (RA) für einen Dual-Mode-Betrieb - im Sendemodus und im Empfangsmodus - in dem Diodengitter zwischen dem ersten, mit der Masse verbundenen Verbindungspunkt (C) und der Anode einer der Dioden des Diodengitters in Serie geschaltet ist, wobei das adaptive Netzwerk Mittel aufweist, um einen ersten Zustand eines offenen Kreislaufs im Sendemodus und einen zweiten Zustand eines Kurzschlusses im Empfangsmodus herzustellen.

2. Mischer nach Anspruch 1, **dadurch gekennzeichnet, dass** die Mittel ein Netzwerk aus derartigen Impedanzen umfassen, dass der Frequenz des Empfangssignals, der Frequenz des Signals des lokalen Empfangsoszillators und der Sendefrequenz des Zwischensignals ein Zustand eines Kurzschlusses entspricht und der Frequenz des lokalen Sendeoszillators ein Zustand eines offenen Kreislaufs entspricht.

3. Mischer nach Anspruch 2, **dadurch gekennzeichnet, dass** das Netzwerk aus Impedanzen eine erste Viertelhalbwellenleitung (TL1) mit der Sendefrequenz bei Kurschluss, eine zweite Viertelwellenleitung (TL2) und eine dritte Halbwellenleitung (TL3) mit dieser Sendefrequenz bei offenem Kreislauf umfasst, wobei diese erste, zweite und dritte Leitung jeweils eine charakteristische Impedanz mit einem Wert von 50 Ohm aufweisen und mit dem gemeinsamen Port verbunden sind.

4. Mischer nach Anspruch 1, **dadurch gekennzeichnet, dass** das Filternetzwerk für die Isolierung zwischen den verschiedenen Wegen des Mischers Folgendes umfasst: ein Funkfrequenzfilter, das mit dem Port für den Funkfrequenzweg verbunden ist und bei der Sendefrequenz des Zwischensignals sowie bei den Frequenzen des lokalen Empfangs- und Sendeoszillators einen offenen Kreislauf aufweist, ein Filter für einen lokalen Oszillator, das mit dem Port für den Weg eines lokalen Oszillators verbunden ist und bei den Sende- bzw. Empfangsfrequenzen einen offenen Kreislauf aufweist, und ein Zwischenfrequenzfilter, das mit dem Port für den Zwischenfrequenzweg verbunden ist und bei der Empfangsfrequenz sowie bei den Frequenzen des lokalen Empfangs- und Sendeoszillators einen offenen Kreislauf aufweist, und dass die Filter in Hinblick auf ihre Betriebsnennfrequenz angepasst sind.
